# EUROPEAN PATENT SPECIFICATION

(11) **EP 2 640 572 B1**
(45) Date of publication and mention of the grant of the patent: **22.11.2017**
(21) Application number: 11782322.9
(22) Date of filing: 28.10.2011
(51) Int. Cl.: B32B 17/10

(54) **METHOD OF REDUCING ELECTROMIGRATION OF SILVER AND ARTICLE MADE THEREBY**
VERFAHREN ZUR VERRINGERUNG DER ELEKTROMIGRATION VON SILBER UND AUF DIESE WEISE HERGESTELLTER ARTIKEL
PROCÉDÉ DE RÉDUCTION DE L'ÉLECTROMIGRATION DE L'ARGENT ET ARTICLE FABRIQUÉ SELON CE PROCÉDÉ

(30) Priority: 17.11.2010 US 414688 P
(43) Date of publication of application: 25.09.2013
(73) Proprietor: 3M Innovative Properties Company, St. Paul, MN 55133-3427 (US)
(72) Inventor: IYER, Suresh S., Saint Paul Minnesota 55133-3427 (US); YANG, Yu, Saint Paul Minnesota 55133-3427 (US); PELLERITE, Mark J., Saint Paul Minnesota 55133-3427 (US); NAGARKAR, Pradnya V., Saint Paul Minnesota 55133-3427 (US)
(74) Representative: Herzog, Fiesser & Partner Patentanwälte PartG mbB
(86) International application number: PCT/US2011/058322
(87) International publication number: WO 2012/067789

(56) References cited:
- EP-A1- 0 942 351
- WO-A1-2006/089649
- DE-A1-102005 003 627
- DE-A1-102009 013 903
- JP-A- 8 133 792
- JP-A- 2005 220 378
- JP-A- 2010 062 241
- JP-A- 2010 143 802
- KR-A- 20090 019 059
- US-A1- 2005 083 307
- US-B1- 6 305 073

## Description

### BACKGROUND

Chemically-strengthened glass (CSG), also known in the art as "chemically-toughened glass", is a type of glass that has increased strength as a result of a post-production chemical process. The glass is chemically-strengthened by submersion in a bath of molten alkali metal salt (typically potassium nitrate) at elevated temperature (e.g., about 450 °C). This causes sodium ions in the glass surface to be replaced by cations from the bath.

There is also a more advanced two-stage process for making CSG, in which the glass article is first immersed in a bath of sodium nitrate bath at elevated temperature (e.g., about 450 °C), which enriches the surface with sodium ions. This leaves more sodium ions on the glass for the secondary immersion in the bath of molten salt to replace.

Chemical strengthening results in a strengthening similar to toughened glass, and has been used as a support for electronic devices such as, for example, touch sensors. In such devices, silver conductive elements may contact the CSG under conditions of prolonged humidity and applied voltage thereby causing silver ion migration into the glass potentially resulting in corrosion and delamination of the silver from the glass.

To combat this problem, epoxy resin-based barrier coats have been applied over and/or under the silver. One commercially available 2-component insulating paste useful as a barrier coat is available as CR-420-1 from Asahi Chemical Research Laboratory Co., Ltd. of Tokyo, Japan. Yet, there remains a need for barrier coats that exhibit improved humidity/moisture barrier properties.

### SUMMARY

In one aspect, the present disclosure provides a method comprising:
providing a conductive member disposed on a portion of a surface of chemically-strengthened glass, wherein the conductive member comprises silver;
disposing a layer comprising a curable polysilazane onto at least a portion of the conductive member and at least a portion of the surface of the chemically-strengthened glass adjacent to the conductive member; and
curing the curable polysilazane.

In another aspect, the present disclosure provides an article comprising:
a conductive member disposed on a portion of a surface of chemically-strengthened glass, wherein the conductive member comprises silver;
a layer comprising a cured reaction product of components comprising a curable polysilazane on at least a portion of the conductive member and at least a portion of the surface of the chemically-strengthened glass adjacent to the conductive member.

Advantageously, and unexpectedly polysilazane-based barrier coatings according to the present disclosure are effective at mitigating the effects of humidity, and may surpass commercially available current alternatives. For example, polysilazane-based barrier coatings according to the present disclosure may prevent silver electro-migration at 85°C and 85 percent relative humidity (RH) for more than 1000 hours.

In addition, polysilazane-based barrier coatings according to the present disclosure can be supplied in a fluid form that permits "coating on demand" digital dispensing methods (e.g., valve jet printing, spray jet printing, and/or ink jet printing).

Objects and advantages of this disclosure are further illustrated by the following non-limiting examples, but the particular materials and amounts thereof recited in these examples, as well as other conditions and details, should not be construed to unduly limit this disclosure.

### BRIEF DESCRIPTION OF THE DRAWINGS

FIG. 1 is a schematic cross-sectional view of an exemplary article 100 according to the present disclosure.
FIG. 2 shows Comparative Example A after being subjected to the electromigration test for 15 minutes.
FIG. 3 shows Comparative Example A after being subjected to the electromigration test for 60 minutes.
FIG. 4 shows Example 1 after being subjected to the electromigration test for 15 minutes.
FIG. 5 shows Example 1 after being subjected to the electromigration test for 48 hours.

While the above-identified drawing figure sets forth several embodiments of the present disclosure, other embodiments are also contemplated, as noted in the discussion. In all cases, this disclosure presents the disclosure by way of representation and not limitation. It should be understood that numerous other modifications and embodiments can be devised by those skilled in the art, which fall within the scope and spirit of the principles of the disclosure. Figures may not be drawn to scale.

### DETAILED DESCRIPTION

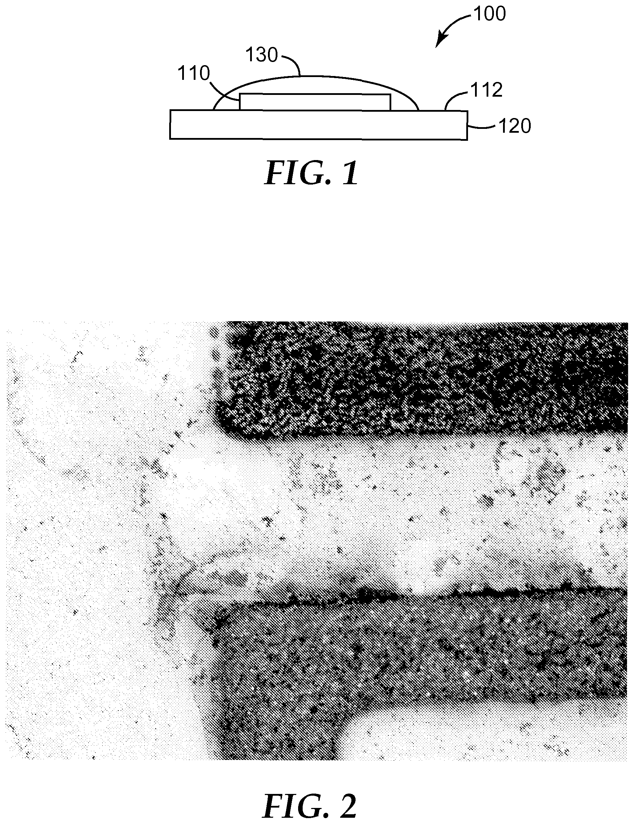

Referring now to FIG. 1, exemplary article 100 comprises conductive member 110 disposed on a portion of a surface 112 of chemically-strengthened glass 120. Conductive member 110 comprises silver. A layer 130 comprising a cured (crosslinked) polysilazane is disposed on conductive member 110 and a portion of the surface 112 of the chemically-strengthened glass 120 adjacent to conductive member 110.

As discussed hereinabove, chemically-strengthened glass 120 is a type of silica-based glass (for example, an alkali aluminosilicate glass or other suitable alkali-containing glass) that has been strengthened by ion-exchange. Generally, chemically-strengthened glass has been produced by immersion of annealed glass in a heated liquid containing alkali metal salt (typically a bath of molten alkali metal salt) resulting in an ion exchange between the salt and the glass, wherein sodium ions near the surface of the glass have been replaced by alkali metal ions from the salt. Typically, the salt comprises a potassium salt (for example potassium nitrate), but other salts may be used. Exemplary other salts include salts of cesium and rubidium, especially if used to exchange potassium ions that have previously been ion-exchanged into the glass. Similarly, other alkali metal salts such as, for example, sulfates and halides may be used in the ion-exchange process. One characteristic of chemically-strengthened glass is that the ion-exchange of sodium with larger ions causes the surface of the glass to be distorted (expansion), thus putting the surface of the glass in a state of compression, while the core of the glass is placed in a state of tension. Generally, the times and temperatures for ion-exchange are 380-460°C and 3-16 hours. Chemically-strengthened glass is widely available from commercial suppliers such as, for example, Corning, Inc. of Corning, New York under the trade designation GORILLA GLASS, or EuropTec USA Inc. of Clarksburg, West Virginia under the trade designation EAGLE ETCH chemically-strengthened glass.

Layer 130 comprises a cured reaction product of components comprising a curable polysilazane. Curable polysilazanes are well known in the art and are available from commercial sources. Examples include polysilazanes represented by the general formula: 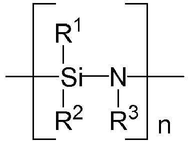 wherein R¹, R², and R³ independently represent hydrogen, optionally substituted alkyl (for example, methyl, ethyl, methoxymethyl, isopropyl, propyl, butyl, hexyl, or octyl), optionally substituted vinyl, or optionally substituted aryl (for example, phenyl or tolyl), and n is a number greater than 5. Commercial suppliers of curable polysilazanes include, for example, KiON Specialty Polymers of Charlotte, North Carolina.

In some embodiments, the curable polysilazane comprises first divalent groups represented by the formula 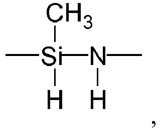 and second divalent groups represented by the formula 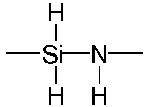 wherein a weight ratio of the first divalent groups to the second divalent groups is in a range of from 20:80 to 40:60, although this is not a requirement. For example, a weight ratio of the first divalent groups to the second divalent groups may be in a range of from 25:80 to 35:60. Synthetic methodology for synthesis of such curable polysilazanes is reported in the Examples section, hereinbelow.

In some embodiments, the polysilazane may contain vinyl groups. For example, the polysilazane may include divalent groups, typically in combination with one or more of the forgoing divalent groups, such as 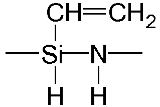 For example, the polysilazane may be generally represented by the formula 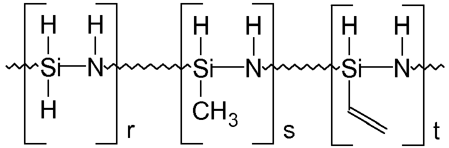 Wherein r, s, and t are positive numbers (e.g., 30, 50, 20). In the above formula, it will be understood that, in the above formula, the groups may be randomly distributed along the polymer backbone, and need to be a triblock polymer. Examples of commercially available polysilizanes that contain vinyl groups include KiON CERASET POLYSILAZANE 20 from KiOn of Charlotte, North Carolina. Such polysilazanes may optionally be used in conjunction with a thermal free-radical initiator (e.g., a peroxide initiator) or a photoinitiator that generates free-radicals upon exposure to actinic radiation. Such materials are well known in the art.

The curable polysilazane may be applied to the conductive member and chemically strengthened glass as a solution in organic solvent; for example, according to conventional liquid coating techniques such as spraying (including spray jet printing, valve jet printing, and ink jet printing), screen printing, bar coating, and flexographic printing.

The layer comprising the curable polysilazane, after removal of volatile solvents and/or curing, normally has a thickness of from about 0.1 to about 10 micrometers,, more typically, for about 0.1 to about 5 micrometers,, and even more typically from about 0.1 to about one micrometer, although other thicknesses may also be used.

Suitable solvents include anhydrous organic solvents that are free of reactive groups (for example, such as hydroxyl or amine groups). Examples include aliphatic or aromatic hydrocarbons, halogenated hydrocarbons, esters, ketones, and ethers.

Optionally, various additives may be used in combination with the curable polysilazane, which may, for example, influence viscosity, substrate wetting, film formation, and/or evaporation behavior. Inorganic nanoparticles such as SiO₂, Ti O₂, ZnO, ZrO₂, or Al₂O₃, may also be included.

Catalysts used may used to facilitate curing (that is, crosslinking) of the polysilazane. Exemplary catalysts include organic amines, acids, or metals or metal salts, or mixtures thereof. Any optional catalyst is generally used in an effective amount, typically in an amount of from 0.001 to 10 percent by weight, more typically in an amount of from 1 to 10 percent by weight, based on the total weight of polysilazane.

Examples of amine catalysts are diethylamine, triethylamine, n-propylamine, isopropylamine, di-n-propylamine, diisopropylamine, and tri-n-propylamine.

Curing of the polysilazane may be accomplished by heating at a temperature of from about 150°C to 500°C; for example, at a temperature of from 180°C to 350°C, or from 200°C to 300°C. The drying time is usually 10 to 120 seconds, depending on the film thickness. Heating may be accomplished, for example, using ovens, blowers, radiant heaters.

Methods according to the present disclosure are well-suited to the manufacture of electronic devices. Exemplary electronic devices include capacitive touch sensors; for example, as disclosed in U.S. Pat. Nos. 6,970,160 (Mulligan et al.) and 6,961,049 (Mulligan et al.), the disclosures of which are incorporated herein by reference.

### SELECT EMBODIMENTS OF THE DISCLOSURE

In a first embodiment, the present disclosure provides a method comprising:
providing a conductive member disposed on a portion of a surface of chemically-strengthened glass, wherein the conductive member comprises silver;
disposing a layer comprising a curable polysilazane onto at least a portion of the conductive member and at least a portion of the surface of the chemically-strengthened glass adjacent to the conductive member; and
curing the curable polysilazane.
In a second embodiment, the present disclosure provides a method according to the first embodiment, wherein the conductive member comprises at least 99 percent by weight of the silver.

In a third embodiment, the present disclosure provides a method according to the first or second embodiment, wherein the polysilazane comprises first divalent groups represented by the formula 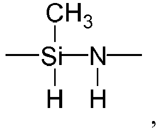 and second divalent groups represented by the formula 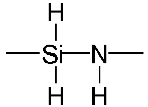 wherein a weight ratio of the first divalent groups to the second divalent groups is in a range of from 20:80 to 40:60.

In a fourth embodiment, the present disclosure provides a method according to the first or second embodiment, wherein a weight ratio of the first divalent groups to the second divalent groups is about 30:70.

In a fifth embodiment, the present disclosure provides an article comprising:
a conductive member disposed on a portion of a surface of chemically-strengthened glass, wherein the conductive member comprises silver;
a layer comprising a cured reaction product of components comprising a curable polysilazane on at least a portion of the conductive member and at least a portion of the surface of the chemically-strengthened glass adjacent to the conductive member.

In a sixth embodiment, the present disclosure provides a method according to the sixth embodiment, wherein the conductive member comprises at least 99 percent by weight of the silver.

In a seventh embodiment, the present disclosure provides a method according to the fifth or sixth embodiment, wherein the polysilazane comprises first divalent groups represented by the formula 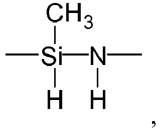 and second divalent groups represented by the formula 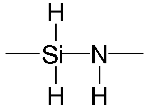 wherein a weight ratio of the first divalent groups to the second divalent groups is in a range of from 20:80 to 40:60.

In a seventh embodiment, the present disclosure provides a method according to the fifth or sixth embodiment, wherein a weight ratio of the first divalent groups to the second divalent groups is about 30:70.

Objects and advantages of this disclosure are further illustrated by the following non-limiting examples, but the particular materials and amounts thereof recited in these examples, as well as other conditions and details, should not be construed to unduly limit this disclosure.

### EXAMPLES

Unless otherwise noted, all parts, percentages, ratios, etc. in the Examples and the rest of the specification are by weight.

### PREPARATION OF CURABLE POLYSILAZANE

A 2-liter three-necked flask equipped with a mechanical stirrer, dry ice/ acetone condenser, and an ammonia inlet tube were charged with 800 ml of hexane and 66.4 g of anhydrous pyridine (0.84 mol). Dichlorosilane (169.7 g, 50 percent in xylene, 0.42 mol,) was added dropwise to the flask. White solid pyridine adduct was produced and precipitated out. After addition was complete, the slurry was stirred at room temperature for another hour. Methyldichlorosilane (20.7 g, 0.18 mol) was then added to the solution, and ammonia was slowly bubbled into the flask. The temperature increased. Addition was continued until 35 g of ammonia had been added. The produced salt was filtered off. Evaporation of solvent gave 16.9 g of viscous polysilazane stoichiometrically represented by the formula 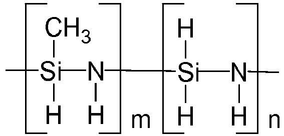 wherein m = 7 and n = 3.

### EXAMPLE 1

A solution of the above curable polysilazane (20 percent in heptane) was coated using a number 12 Meyer rod (1.08 mils (27 microns) nominal wet thickness) onto a piece of EAGLE ETCH chemically-strengthened glass from EuropTec USA Inc. of Clarksburg, West Virginia that had silver traces thereon. The Dry-to-touch time was about one minute. The silver traces were patterned to form a ladder with broken rungs separated by one millimeter. The silver traces were approximately 5-6 microns in thickness, and were screen printed using silver ink (available as ERCON 5600 from Ercon Inc. of Wareham, Massachusetts) dried at 150°C for 30 minutes). The sample was cured in a chamber (60 °C, 95% RH) overnight.

### COMPARATIVE EXAMPLE A

Example 1 was repeated, except that no polysilazane coating was applied.

### ELECTROMIGRATION TEST

Conducting wires were attached to opposite ends of a printed silver traces ladder using copper tape. The conducting wires were connected to a 9V battery, and the gap between the silver electrodes was covered with two drops of water. The specimen and water were covered with a glass cover to keep water from evaporating during the test. An optical microscope (50X) was used to monitor electromigration in the silver traces as a function of time. Coating thickness was measured using a digital film calibrator.

Specimens prepared according to Example 1, and Comparative Examples A-C were subjected to the *ELECTROMIGRATION TEST* (above).

FIG. 2 shows Comparative Example A after being subjected to the electromigration test for 15 minutes.

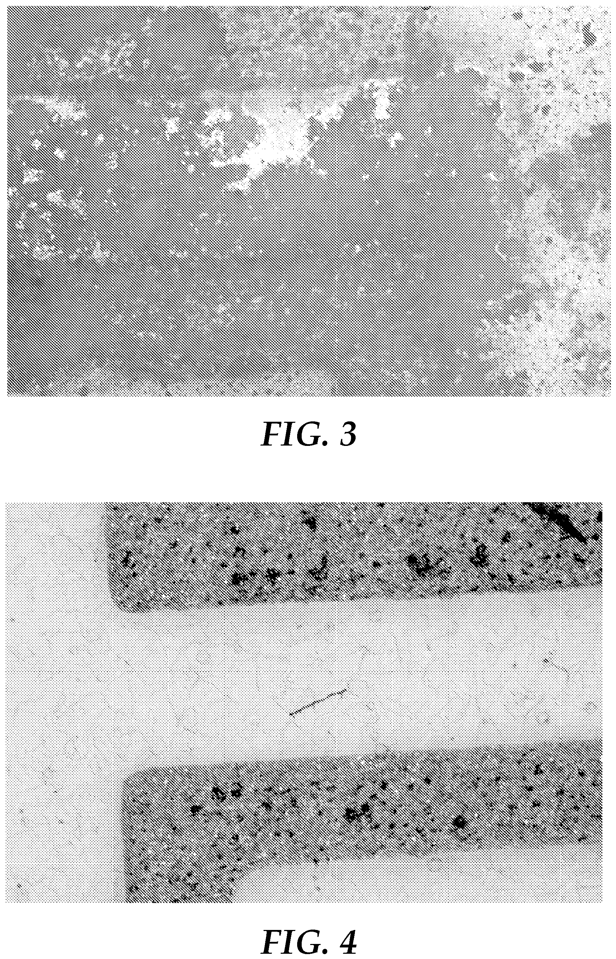

FIG. 3 shows Comparative Example A after being subjected to the electromigration test for 60 minutes.

FIG. 4 shows Example 1 after being subjected to the electromigration test for 15 minutes.

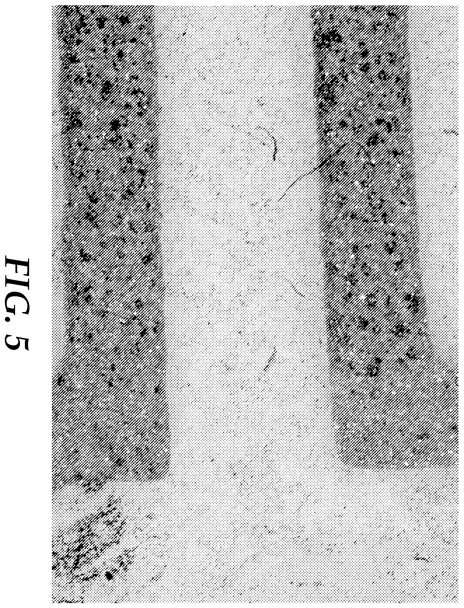

FIG. 5 shows Example 1 after being subjected to the electromigration test for 48 hours.

A specimen prepared as in Example 1, and subjected to the Electromigration Test remained visually unchanged after 9 days at room temperature.

### COMPARATIVE EXAMPLE B

The procedure of Example 1 was repeated except that Asahi PTF epoxy resin paste, (available as CR-420-1 from Asahi Chemical Research Laboratory Co. Ltd. of Tokyo, Japan) was used instead of the polysilazane. The specimen was exposed to 80°C and 95% R.H. under 10V applied voltage. Corrosion of the printed silver was observed after seven days.

### EXAMPLE 2

The procedure of Comparative Example B was repeated, except that curable silane A was used instead of the epoxy resin paste. No visible corrosion of the printed silver was observed after 60 days.

## Claims

1. A method comprising:
providing a conductive member disposed on a portion of a surface of chemically-strengthened glass, wherein the conductive member comprises silver;
disposing a layer comprising a curable polysilazane onto at least a portion of the conductive member and at least a portion of the surface of the chemically-strengthened glass adjacent to the conductive member; and
curing the curable polysilazane.

2. The method of claim 1, wherein the conductive member comprises at least 99 percent by weight of the silver.

3. The method of claim 1 or 2, wherein the curable polysilazane comprises first divalent groups represented by the formula 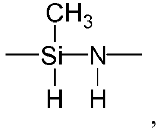 and second divalent groups represented by the formula 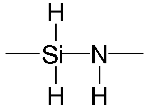 wherein a weight ratio of the first divalent groups to the second divalent groups is in a range of from 20:80 to 40:60.

4. The method of claim 1 or 2, wherein a weight ratio of the first divalent groups to the second divalent groups is about 30:70.

5. An electronic article comprising:
a conductive member disposed on a portion of a surface of chemically-strengthened glass, wherein the conductive member comprises silver;
a layer comprising a cured reaction product of components comprising a curable polysilazane on at least a portion of the conductive member and at least a portion of the surface of the chemically-strengthened glass adjacent to the conductive member.

6. The article of claim 5, wherein the conductive member comprises at least 99 percent by weight of the silver.

7. The article of claim 5 or 6, wherein the curable polysilazane comprises first divalent groups represented by the formula 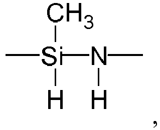 and second divalent groups represented by the formula 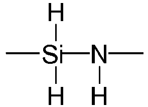 wherein a weight ratio of the first divalent groups to the second divalent groups is in a range of from 20:80 to 40:60.

8. The article of claim 5 or 6, wherein a weight ratio of the first divalent groups to the second divalent groups is about 30:70.

## Patentansprüche

1. Verfahren, umfassend:
Bereitstellen eines leitenden Elements, das auf einem Teil einer Oberfläche von chemisch verfestigtem Glas angeordnet ist, wobei das leitende Element Silber umfasst;
Ablegen einer Schicht, die ein aushärtbares Polysilazan umfasst, auf mindestens einen Teil des leitenden Elements und mindestens einen Teil der Oberfläche des chemisch verfestigten Glases, die an das leitende Element angrenzt; und
Härten des härtbaren Polysilazans.

2. Verfahren nach Anspruch 1, wobei das leitende Element mindestens 99 Gew.-% des Silbers umfasst.

3. Verfahren nach Anspruch 1 oder 2, wobei das härtbare Polysilazan erste zweiwertige Gruppen, dargestellt durch die Formel 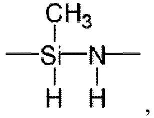 und zweite zweiwertige Gruppen, dargestellt durch die Formel, umfasst 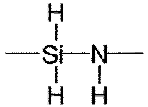 wobei ein Gewichtsverhältnis der ersten zweiwertigen Gruppen zu den zweiten zweiwertigen Gruppen in einem Bereich von 20:80 bis 40:60 liegt.

4. Verfahren nach Anspruch 1 oder 2, wobei ein Gewichtsverhältnis der ersten zweiwertigen Gruppen zu den zweiten zweiwertigen Gruppen etwa 30:70 beträgt.

5. Elektronischer Artikel, umfassend:
ein leitendes Element, das auf einem Teil einer Oberfläche von chemisch verfestigtem Glas angeordnet ist, wobei das leitende Element Silber umfasst;
eine Schicht, die ein gehärtetes Reaktionsprodukt aus Komponenten umfasst, die ein härtbares Polysilazan auf mindestens einem Teil des leitenden Elements und mindestens einem Teil der Oberfläche des chemisch verfestigten Glases, die an das leitende Element angrenzt, umfassen.

6. Artikel nach Anspruch 5, wobei das leitende Element mindestens 99 Gew.-% des Silbers umfasst.

7. Artikel nach Anspruch 5 oder 6, wobei das härtbare Polysilazan erste zweiwertige Gruppen, dargestellt durch die Formel 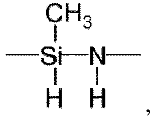 und zweite zweiwertige Gruppen, dargestellt durch die Formel, umfasst 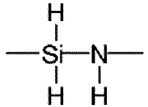 wobei ein Gewichtsverhältnis der ersten zweiwertigen Gruppen zu den zweiten zweiwertigen Gruppen in einem Bereich von 20:80 bis 40:60 liegt.

8. Artikel nach Anspruch 5 oder 6, wobei ein Gewichtsverhältnis der ersten zweiwertigen Gruppen zu den zweiten zweiwertigen Gruppen etwa 30:70 beträgt.

## Revendications

1. Procédé comprenant :
la fourniture d'un élément conducteur disposé sur une partie d'une surface de verre chimiquement renforcé, dans lequel l'élément conducteur comprend de l'argent ;
la mise en place d'une couche comprenant un polysilazane durcissable sur au moins une partie de l'élément conducteur et au moins une partie de la surface du verre chimiquement renforcé adjacente à l'élément conducteur ; et
le durcissement du polysilazane durcissable.

2. Procédé selon la revendication 1, dans lequel l'élément conducteur comprend au moins 99 pour cent en poids de l'argent.

3. Procédé selon la revendication 1 ou 2, dans lequel le polysilazane durcissable comprend des premiers groupes divalents représentés par la formule 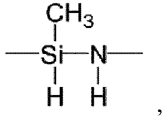 et des deuxièmes groupes divalents représentés par la formule 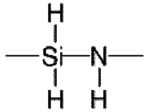 dans lequel un rapport pondéral des premiers groupes divalents aux deuxièmes groupes divalents est dans une plage allant de 20:80 à 40:60.

4. Procédé selon la revendication 1 ou 2, dans lequel un rapport pondéral des premiers groupes divalents aux deuxièmes groupes divalents est environ 30:70.

5. Article électronique comprenant :
un élément conducteur disposé sur une partie d'une surface de verre chimiquement renforcé, dans lequel l'élément conducteur comprend de l'argent ;
une couche comprenant un produit de réaction durci de composants comprenant un polysilazane durcissable sur au moins une partie de l'élément conducteur et au moins une partie de la surface du verre chimiquement renforcé adjacente à l'élément conducteur.

6. Article selon la revendication 5, dans lequel l'élément conducteur comprend au moins 99 pour cent en poids de l'argent.

7. Article selon la revendication 5 ou 6, dans lequel le polysilazane durcissable comprend des premiers groupes divalents représentés par la formule 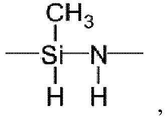 et des deuxièmes groupes divalents représentés par la formule 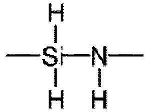 dans lequel un rapport pondéral des premiers groupes divalents aux deuxièmes groupes divalents est dans une plage allant de 20:80 à 40:60.

8. Article selon la revendication 5 ou 6, dans lequel un rapport pondéral des premiers groupes divalents aux deuxièmes groupes divalents est environ 30:70.
